# EUROPÄISCHE PATENTSCHRIFT

(11) **EP 2 221 667 B1**
(45) Veröffentlichungstag und Bekanntmachung des Hinweises auf die Patenterteilung: **05.04.2017**
(21) Anmeldenummer: 10001252.5
(22) Anmeldetag: 08.02.2010
(51) Int. Cl.: G03F 7/20, F16F 15/027, G05D 19/02

(54) **Kombinierter Bewegungssensor zum Einsatz in Feedback-Regelsystemen zur Schwingungsisolation**
Combined motion sensor for use in feedback regulation systems for vibration isolation
Détecteur combiné de mouvement à utiliser dans des systèmes de réglage par rétroaction destinés à l'isolation de vibrations

(30) Priorität: 19.02.2009 DE 102009009562
(43) Veröffentlichungstag der Anmeldung: 25.08.2010
(73) Patentinhaber: Integrated Dynamics Engineering GmbH, 65479 Raunheim (DE)
(72) Erfinder: Heiland, Peter, 65479 Raunheim (DE)
(74) Vertreter: Blumbach Zinngrebe

(56) Entgegenhaltungen:
- EP-A1- 1 840 681
- WO-A2-2007/072357
- DE-A1- 10 356 561
- US-A1- 2002 117 109

## Beschreibung

### Beschreibung der Erfindung

Die vorliegende Erfindung betrifft ein aktives Schwingungsisolationssystem zur schwingungsisolierten Lagerung von Lithographie-Einrichtungen, Wafer-Handhabungssystemen und/oder Mikroskopen, wie zum Beispiel Rastermikroskopen.

### Hintergrund der Erfindung

Schwingungsisolationssysteme sind bekannt und werden in vielen Bereichen der Technik, wie zum Beispiel im Bereich der Halbleiterindustrie, benötigt. Beispielsweise zeigt die DE 69817750 T2 ein Schwingungsisolationssystem, welches insbesondere zur schwingungsisolierten Lagerung eines Lithographiegerätes vorgesehen ist. Dabei wird eine zu lagernde Last, welche typischerweise ein Tisch und darauf gelagerte Bauelemente, wie zum Beispiel Fertigungsanlagen, umfasst, auf Luftlagern gelagert.

Neben einer Lagerung mit möglichst mechanisch geringer Steifigkeit weisen aktive Schwingungsisolationssysteme Sensoren und Aktoren auf, mit denen gezielt von außen in das System eindringenden Schwingungen entgegengesteuert wird. Die Sensoren erfassen dabei Bewegungen der zu lagernden Last. Über eine Regeleinrichtung werden Kompensationssignale generiert, mit denen Aktoren angesteuert und so Kompensationsbewegungen generiert werden. Dabei gibt es die Möglichkeit, digitale oder analoge Regelungsstrecken zu verwenden oder aber auch beide zusammen, sogenannte hybride Regelungsstrecken.
Die Anforderungen an Schwingungsisolationssysteme nehmen mit zunehmender Miniaturisierung in der Halbleiterindustrie immer weiter zu. Typischerweise werden als Sensoren im Stand der Technik sogenannte Geophone eingesetzt, um die Massenbewegungen aufzunehmen.

Ein Geophon ist ein elektro-mechanischer Wandler, welcher die erfassten Schwingungen in analoge und/oder digitale Signale wandelt. Ein Geophon besteht im Allgemeinen im Wesentlichen aus einer Spule und einem Permanentmagneten, wobei die Spule über eine Feder mit dem Permanentmagneten gekoppelt ist. Bei einer durch eine Schwingung verursachten Relativbewegung zwischen Spule und Magnet wird in die Spule eine Spannung induziert, welche proportional zur Geschwindigkeit der Bewegung ist. Geophone sind günstig in der Anschaffung und können durch geeignete Maßnahmen einen Frequenzganz haben, der bis zu sehr tiefen Frequenzen reicht, insbesondere bis 0.1 Hz oder sogar tiefer. Dagegen reicht die Frequenzgangbandbreite eines Geophons zu hohen Frequenzen im Allgemeinen nur bis zu etwa 300 Hz, was in den meisten Fällen zur Schwingungsisolation ausreichend ist. Eine Erfassung von höheren Frequenzen ist mit dem Geophon selbst jedoch nicht möglich.

DE 103 56 561 A1 offenbart eine Vorrichtung und ein Verfahren zur Positionierung einer Stelleinrichtung gegenüber einem Trägerelement. Es ist dabei wenigstens ein Messsystem vorgesehen, wobei zur Messung einer Ist-Position und zur Kontrolle der Bewegung der Stelleinrichtung wenigstens eine Kombination eines Bewegungsdifferenzen messenden Messsystems und eines gegen ein Inertialsystem messenden Messsystems, welches an der Stelleinrichtung angeordnet ist, vorgesehen ist.

WO 2007/072357 A2 beschreibt ein gemischtes Sensorensystem umfassend einen Geschwindigkeitssensor, der operativ verbunden ist, um die Geschwindigkeit einer schweren Masse zu überwachen und ein Geschwindigkeitssignal zu erzeugen, einen Positionssensor , der operativ verbunden ist, um die Position der schweren Masse zu überwachen und ein Positionssignal zu erzeugen, und eine Summiereinrichtung zum Erzeugen eines gemischten Signals aus dem Geschwindigkeitssignal und dem Positionssignal.

### Allgemeine Beschreibung der Erfindung

Vor diesem Hintergrund hat sich die vorliegende Erfindung daher zur Aufgabe gestellt, eine Vorrichtung und ein Verfahren zur aktiven Schwingungsisolation bereitzustellen, welche die vorstehend beschriebenen Nachteile des Standes der Technik zumindest vermindern.

Dabei soll die Regelbandbreite der Schwingungsisolation zu großen Frequenzen hin erweitert werden.

Hierbei soll es insbesondere möglich sein, die Erfindung in bereits bestehende Regelungskonzepte integrieren zu können bzw. die bekannten Regelungskonzepte erweitern zu können.

Gelöst werden die genannten Aufgaben durch ein aktives Schwingungsisolationssystem und ein Verfahren zur Regelung eines Schwingungsisolationssystems gemäß der unabhängigen Ansprüche.

Vorteilhafte Ausführungsformen sind Gegenstand der jeweiligen Unteransprüche.

Allgemein basiert die Erfindung auf der Verwendung einer Kombination aus zwei unterschiedlichen Typen von Sensoren zur Erhöhung der Regelbandbreite von an sich bekannten Schwingungsisolationssystemen.

In einer ersten Ausführungsform beansprucht die vorliegende Anmeldung ein aktives Schwingungsisolationssystem, insbesondere zur schwingungsisolierten Lagerung von Lithographie-Einrichtungen, Wafer-Handhabungssystemen und/oder Mikroskopen, umfassend
- eine Vielzahl von Schwingungssignalgebern zur Lieferung von Schwingungen repräsentierenden Sensorsignalen,
- eine Anzahl von Aktoren zur Schwingungskompensation, welche durch Zuführen von Aktor-Stellsignalen ansteuerbar sind,
- eine Regeleinrichtung, die zum Verarbeiten der gelieferten Sensorsignale in die Aktor-Stellsignale ausgebildet ist,
- wobei die Schwingungssignalgeber
   wenigstens einen ersten Beschleunigungssensor, der vorzugsweise als ein Geophonsensor ausgebildet ist, zur Erfassung von Schwingungen in einem ersten Frequenzbereich und
   wenigstens einen zweiten, gegenüber dem ersten unterschiedlichen Beschleunigungssensor zur Erfassung von Schwingungen in einem zweiten Frequenzbereich, welcher den ersten Frequenzbereich erweitert, aufweisen.

Weiterhin liegt im Rahmen der Erfindung auch ein Verfahren zur Regelung eines aktiven Schwingungsisolationssystems, insbesondere zur schwingungsisolierten Lagerung von Lithographie-Einrichtungen, Wafer-Handhabungssystemen und/oder Mikroskopen, das die folgenden Schritte umfasst:
- Erfassen von Schwingungen mittels einer Vielzahl von Schwingungssignalgebern,
- Bereitstellen von Sensorsignalen, welche die erfassten Schwingungen repräsentieren,
- Verarbeiten der bereitgestellten Sensorsignale zu Aktor-Stellsignalen zum Steuern von Aktoren,
- Zuführen der Aktor-Stellsignale zu den Aktoren zum Entgegenwirken der Schwingungen, wobei
die Schwingungssignalgeber durch wenigstens einen ersten Beschleunigungssensor, der vorzugsweise als ein Geophonsensor ausgebildet ist, zur Erfassung von Schwingungen in einem ersten Frequenzbereich und
wenigstens einen zweiten, gegenüber dem ersten unterschiedlichen Beschleunigungssensor zur Erfassung von Schwingungen in einem zweiten Frequenzbereich, welcher den ersten Frequenzbereich erweitert, bereitgestellt werden und
die Sensorsignale des ersten Beschleunigungssensors und der Sensorsignale des zweiten Beschleunigungssensors zu gemeinsamen Aktor-Stellsignalen zum Ansteuern der Aktoren zusammengeführt werden.

Das erfindungsgemäße Verfahren ist insbesondere ausführbar mittels dem erfindungsgemäßen System. Das erfindungsgemäße System ist insbesondere ausgebildet zur Ausführung des erfindungsgemäßen Verfahrens.

Die Sensorsignale können analoge und/oder digitale Signale sein. Ein Sensorsignal kann ein Signal sein, welches nur die Schwingungen oder eine Störgröße in einem Freiheitsgrad erfasst. Das Sensorsignal kann aber auch ein Signal sein, das die Schwingungen oder eine Störgröße in einer Vielzahl von Freiheitsgraden erfasst. Die genannte Vielzahl von Schwingungssignalgebern entspricht einer Anzahl von mindestens zwei oder mehr Schwingungssignalgebern.

Da im Allgemeinen mehr als zwei Sensoren verwendet werden, werden bzw. sind in einer Ausführungsform jeweils ein erster Beschleunigungssensor und ein zweiter Beschleunigungssensor paarweise angeordnet. Damit ein solches Paar die Störgrößen von den gleichen Störquellen und/oder aus der gleichen Richtung erfassen kann, werden bzw. sind der erste und der zweite Beschleunigungssensor in räumlicher Nähe zueinander platziert. In einer bevorzugten Ausführungsform werden bzw. sind sie in einem Abstand von kleiner als etwa 30 cm, vorzugsweise von kleiner als etwa 10 cm, zueinander angeordnet.

Der erste Beschleunigungssensor ist vorzugsweise als ein Geophonsensor ausgebildet. Der erste Frequenzbereich beträgt bis zu etwa 300 Hz. Somit ist der erste Beschleunigungssensor in einem Frequenzbereich von bis zu etwa 300 Hz wirksam.

Um die entsprechende Erweiterung des Frequenzbereichs zu großen Frequenzen hin zu erzielen, ist der zweite Beschleunigungssensor in einem Frequenzbereich, hier dem vorstehend genannten zweiten Frequenzbereich, von bis zu etwa 1,5 kHz, vorzugsweise von bis zu etwa 5 kHz, wirksam. Der zweite Beschleunigungssensor ist in einer Ausführungsform der Erfindung ein piezo-elektrischer Beschleunigungssensor.

In einer Weiterbildung der vorliegenden Erfindung weist das Schwingungsisolationssystem eine Schaltung zum Zusammenführen der Sensorsignale des ersten Beschleunigungssensors und der Sensorsignale des zweiten Beschleunigungssensors zu einem gemeinsamen Aktor-Stellsignal oder zu gemeinsamen Aktor-Stellsignalen zum Ansteuern der Aktoren auf. Sofern sich die erfassten Frequenzen des ersten Beschleunigungssensors und des zweiten Beschleunigungssensors überlappen, so ist in den überlappenden Signalanteilen auf eine korrekte Addition oder Zusammenführung zu achten, ohne die Amplitude in den überlappenden Teilen anzuheben. Dafür ist bzw. sind zum Beispiel zumindest ein Hochpass und/oder zumindest ein Tiefpass zur angepassten Addition der überlappenden Signalanteile und/oder zur Frequenzteilung vorgesehen.

Die Aktor-Stellsignale können analoge und/oder digitale Signale sein. Ein Aktor-Stellssignal stellt eine Art Kompensationssignal dar. Eine Schwingung einer zu lagernden Last wird aktiv kompensiert. Die genannte Anzahl von Aktoren entspricht im Allgemeinen einer Mehrzahl von Aktoren. Die Aktoren können in einem Freiheitsgrad oder in einer Mehrzahl von Freiheitsgraden der Bewegung wirksam sein. Ein Aktor-Stellsignal kann daher ein Signal sein, das Informationen für nur einen Freiheitsgrad beinhaltet. Es kann aber auch ein Signal sein, das Informationen für eine Vielzahl von Freiheitsgraden beinhaltet.

Die Schaltung zum Zusammenführen der Sensorsignale kann als eine analoge und/oder eine digitale Schaltung ausgeführt sein. Ebenso kann die Regeleinrichtung eine digital und/oder eine analog arbeitende Regeleinrichtung sein. In einer ersten Variante der Erfindung sind bzw. werden der erste und der zweite Beschleunigungssensor der einen Regeleinrichtung zugeordnet. Hierbei ist bzw. wird die Regeleinrichtung eingangsseitig mit der Schaltung zum Zusammenführen, vorzugsweise unmittelbar, gekoppelt. Die Regeleinrichtung ist bzw. wird ausgangsseitig mit den Aktoren, vorzugsweise unmittelbar, gekoppelt. In einer zweiten Variante der Erfindung ist bzw. wird die Regeleinrichtung durch eine erste Regeleinrichtung, welcher der erste zweite Beschleunigungssensor zugeordnet ist, und durch eine zweite Regeleinrichtung, welcher der zweite Beschleunigungssensor zugeordnet ist, gebildet. Hierbei sind bzw. werden die erste und die zweite Regeleinrichtung ausgangsseitig mit der Schaltung zum Zusammenführen, vorzugsweise unmittelbar, gekoppelt. Dabei ist bzw. wird die Schaltung zum Zusammenführen ausgangsseitig mit den Akoren, vorzugsweise unmittelbar, gekoppelt.

Die Regeleinrichtung bzw. die erste und/oder die zweite Regeleinrichtung ist bzw. sind vorzugsweise eine sogenannte Rückkopplungsregelung. Beispielsweise sind in einer Ausführung der Regeleinrichtung bzw. der ersten und/oder der zweiten Regeleinrichtung Kompensationssignale, welche auch als Korrektursignale bezeichnet werden können, in drei oder zumindest drei, vorzugsweise in sechs, Freiheitsgraden berechenbar. Hierbei kann neben einer Berechnung der drei Freiheitsgrade der Translation noch durch eine ergänzende Berücksichtigung der drei Freiheitsgrade der Rotation eine verbesserte bzw. genauere Regelung bereitgestellt werden.

Im Bereich der Erfindung liegt auch die Verwendung von Schwingungssignalgebern, umfassend wenigstens einen ersten Beschleunigungssensor zur Erfassung von Schwingungen in einem ersten Frequenzbereich und wenigstens einen zweiten, gegenüber dem ersten Beschleunigungssensor verschiedenen Beschleunigungssensor zur Erfassung von Schwingungen in einem zweiten Frequenzbereich, welcher den ersten Frequenzbereich zu großen Frequenzen hin, insbesondere bis zu 5 kHz, erweitert zur Erfassung von Schwingungen in einem Schwingungsisolationssystem, insbesondere mit zumindest einem Polymer-Federelement. Der erste Beschleunigungssensor ist vorzugsweise als ein Geophonsensor ausgebildet. Der zweite Beschleunigungssensor ist vorzugsweise als ein piezo-elektrischer Sensor ausgebildet.

Die vorliegende Erfindung wird anhand der nachfolgenden Ausführungsbeispiele im Einzelnen erläutert. Hierzu wird auf die beiliegenden Zeichnungen Bezug genommen. Die gleichen Bezugszeichen in den einzelnen Zeichnungen beziehen sich auf die gleichen Teile.

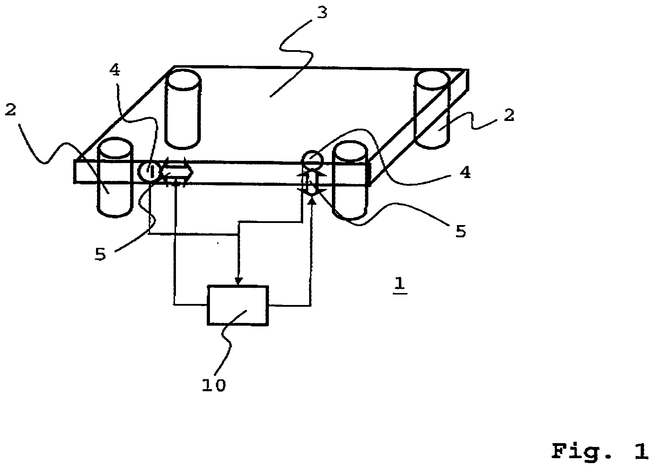

Fig. 1 zeigt schematisch ein beispielhaftes bekanntes aktives Schwingungsisolationssystem.
Fig. 2 zeigt ein Blockschaltbild einer bekannten Anordnung eines Rückkopplungsregelsystems.
Fig. 3 zeigt ein Blockschaltbild einer beispielhaften ersten Ausführungsform der Erfindung.
Fig. 4 zeigt ein Blockschaltbild einer beispielhaften zweiten Ausführungsform der Erfindung.

### Detaillierte Beschreibung der Erfindung

Ein bekanntes erfindungsgemäßes Schwingungsisolationssystem 1 umfasst eine schwingungsisoliert zu lagernde Last 3, beispielsweise in Form eines Tisches 3. Auf dem Tisch 3 können schwingungsisoliert zu lagernde Geräte, welche in der Zeichnung nicht dargestellt sind, platziert werden.

Als Beispiele für die genannten Geräte seien Lithographie-Einrichtungen und/oder Wafer-Handhabungssysteme und/oder Mikroskope, insbesondere Rastermikroskope, genannt. Wafer-Handhabungssysteme sind oder unfassen beispielsweise Einrichtungen zum Transportieren, Lagern, Halten, Greifen, Drehen, Bearbeiten und/oder Untersuchen von Wafern.

Die Last 3 ist auf Lagern 2, beispielsweise auf Luftlagern 2, gelagert. Ein Luftlager 2 stellt ein passives System bzw. ein System zur passiven Schwingungsisolation dar. Ein weiteres Beispiel für ein passives Federsystem ist ein Polymer-Federelement, welches jedoch in den Figuren nicht dargestellt ist.

Zur aktiven Schwingungskompensation verfügt das bekannte Schwingungsisolationssystem 1 über Sensoren 4, insbesondere Geophonsensoren 4, als Schwingungssignalgeber 4. Diese sind in dem dargestellten Ausführungsbeispiel nur für zwei Freiheitsgrade der Translation dargestellt. Über die Geophonsensoren 4 können Schwingungen der zu isolierenden Last 3 erfasst, in Signale umgewandelt und an eine Regeleinrichtung 10 weitergegeben werden. Die Schwingungssignalgeber 4 liefern somit die Schwingungen repräsentierenden Sensorsignale.

Jede Regelung ist darauf angewiesen, Sensorsignale zu bekommen, die proportional sind zur Bewegung, insbesondere der Beschleunigung, der zu isolierenden Masse. Daraus wird die Rückkopplungsregelstrecke 10 dann Kompensationssignale, die vorstehend genannten Aktor-Stellsignale, erzeugen, die zur Ansteuerung von Kraftaktoren verwendet werden, um eine Masse vom sich bewegenden Boden zu isolieren oder allgemein Massenbewegungen zu reduzieren. Die Regeleinrichtung 10 errechnet aus den Sensorsignalen der Geophonsensoren 4 Kompensationssignale zur Ansteuerung von Aktoren 5. Beispiele für die Aktoren 5 umfassen Lorentzmotoren, wie zum Beispiel Tauchspulen, und/oder piezo-elektrische Aktoren. Die Regeleinrichtung 10 ist ausgebildet zum Verarbeiten der gelieferten Sensorsignale in die Aktor-Stellsignale.

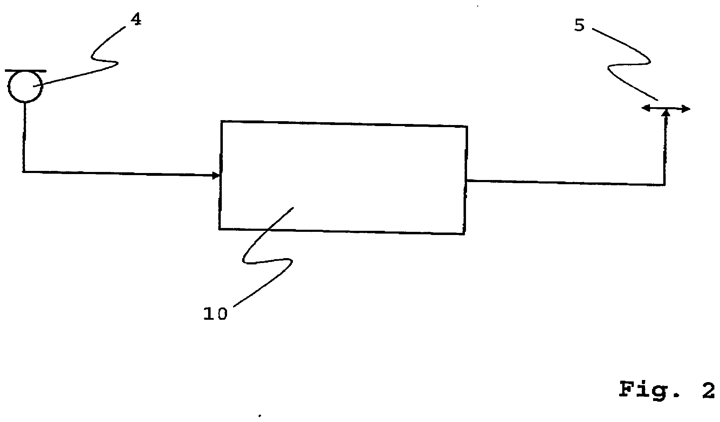

Figur 2 zeigt hierzu ein Blockschaltbild einer bekannten Regeleinrichtung bzw. einer bekannten Anordnung eines Regelungskopplungssystems für ein Geophon 4 als ein erster Beschleunigungssensor. Mit den Aktoren 5 kann eine aktive Schwingungskompensation vorgenommen werden. Gegenüber einer passiven Schwingungsisolation, die durch eine Art Dämpfung der Schwingung oder eine Art "isolierte" Lagerung der Last gekennzeichnet ist, ist eine aktive Schwingungsisolation insbesondere dadurch gekennzeichnet, dass die Schwingung aktiv kompensiert wird. Eine Bewegung, die durch eine Schwingung induziert wird, wird durch eine entsprechende Gegenbewegung kompensiert. Zum Beispiel wird einer durch eine Schwingung induzierten Beschleunigung der Masse eine dem Betrag nach gleich große Beschleunigung jedoch mit entgegengesetzten Vorzeichen entgegengesetzt. Somit ist die resultierende Gesamtbeschleunigung des Last 3 gleich Null. Die Last 3 verharrt in Ruhe bzw. der gewünschten Lage.

Die Frequenzgangbandbreite eines Geophons 4 reicht im Allgemeinen nur bis zu etwa 300 Hz. Dies reicht damit zur Schwingungsisolation in den meisten Fällen aus. Der Grund dafür ist insbesondere, dass die Basis eines solchen Systems ein Feder-Masse-Dämpfer-System bildet. Die Resonanzfrequenz liegt typischerweise unter 5 Hz, meist um 1 Hz, selten unter 0.5 Hz. Die damit passiv erreichte Isolationswirkung ist dann typischerweise bei 300 Hz schon so groß, dass ein Ausdehnen einer Regelbandbreite nicht bis über 150 Hz erforderlich ist. Im Allgemeinen ergibt sich hierbei eine Reduzierung in der Größenordnung von ungefähr -40dB pro Frequenzdekade.

Für bestimmte Anwendungen der Schwingungsisolation ist es notwendig, die Regelbandbreite so groß wie möglich zu machen, vorzugsweise in einem Bereich von bis zu etwa 1.5 kHz oder sogar bis zu etwa 5 kHz. Das kann daran liegen, dass das passive Masse-Feder-System, beispielsweise wegen des Einsatzes von sogenannten Polymer-Federelementen, eine hohe Resonanzfrequenz hat, und/oder aber auch daran, dass die Struktur der Masse und/oder der Last 3 selbst und/oder des Unterbaus 2 eines Isolationssystems 1 zusätzliche Resonanzen ausbilden, die mit in die aktive Regelung und damit in die Kontrolle und Unterdrückung derselben hinzugezogen werden sollen. Insbesondere Strukturresonanzen können dabei leicht Frequenzen im Kilohertz-Bereich haben, welche somit mittels der üblichen Geophonsensoren 4 nicht erschlossen werden können.

Die bekannten Regelungskonzepte sollen beibehalten werden. Die Regelung kann hierbei analog und/oder digital erfolgen. Die Samplingraten für die digitale Regelung liegen in einer Größenordnung von etwa 60 kHz bis 100 kHz. Erfindungsgemäß werden die Sensorsignale so aufbereitet, dass alle oder im Wesentlichen alle Signale aufgenommen werden können und insbesondere in einer solchen Phasenlage zur Verfügung stehen, dass sie sich für eine Rückkopplungsregelung eignen.

Wegen des mechanischen Aufbaus eines Geophons 4 ist es nicht möglich, dessen Frequenzganz auf Frequenzen oberhalb von 300 Hz zu erweitern. Die Erfindung basiert allgemein auf einer Kombination aus einem Geophon als einem ersten Beschleunigungssensor 4a und einem Beschleunigungsaufnehmer als einem zweiten Beschleunigungssensor 4b. Der Beschleunigungsaufnehmer 4b ist vorzugsweise ein piezo-elektrischer Beschleunigungssensor. Es wird ein Signal generiert, welches der Massenbewegung proportional ist und vorzugsweise eine Frequenzbandbreite von bis zu 5 kHz aufweist, vorzugsweise bei gleichzeitiger Phasenlage, die es ermöglicht, das Signal zur Rückkopplungsregelung zu verwenden. Dazu werden die beiden Sensoren, nämlich Geophon 4a und Beschleunigungsaufnehmer 4b, räumlich nahe beieinander platziert. Unter räumlicher Nähe wird ein Abstand der beiden Sensoren 4a und 4b von kleiner als etwa 10 cm verstanden. Werden zum Beispiel eine Vielzahl von ersten und zweiten Beschleunigungssensoren 4a bzw. 4b verwendet, so werden ein erster Beschleunigungssensor 4a und ein zweiter Beschleunigungssensor 4b jeweils sozusagen paarweise angeordnet. Die Sensoren können jeweils mittels einer Klemm- oder einer Schweissverbindung, zum Beispiel an dem Lager 2 und/oder der Last 3, befestigt sein.

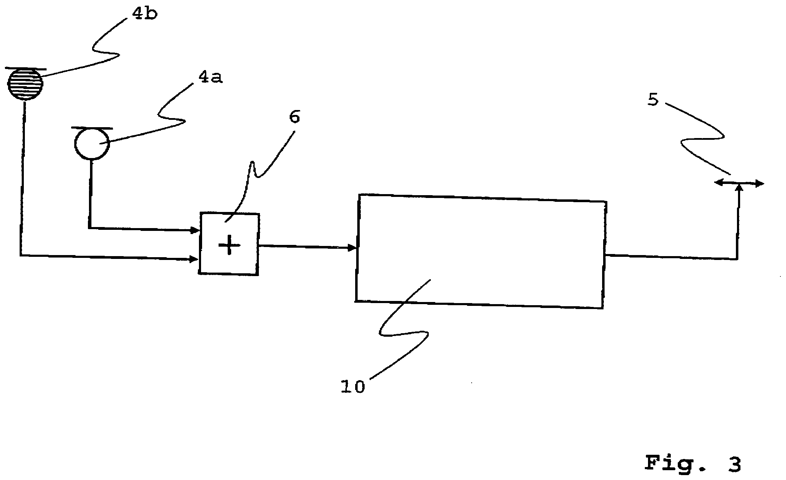

In Figur 3 ist ein Blockschaltbild eines Paares von Sensoren 4a und 4b in einer ersten Ausführungsform der Erfindung gezeigt. Hier werden die jeweiligen Sensorsignale des ersten 4a und des zweiten 4b Beschleunigungssensors zusammengeführt oder addiert, bevor sie in der Rückkopplungsregelung 10 verwendet werden. Dies erfolgt in einem Mittel 6 zum Zusammenführen oder zum Addieren. Die Zusammenführung der beiden Signale kann dabei entweder komplett analog, komplett digital oder in einer Mischform erfolgen. Dabei wird entweder durch Hochpässe und/oder Tiefpässe dafür gesorgt, dass die überlappenden Signalanteile sich korrekt addieren ohne die Amplitude anzuheben, oder aber es wird die "Frequenz-Charakteristik" der Sensoren ausgenutzt. Dabei wird die "natürliche" Hoch- und/oder Tiefpasscharakteristik ausgenutzt, um die Frequenzteilung vorzunehmen.

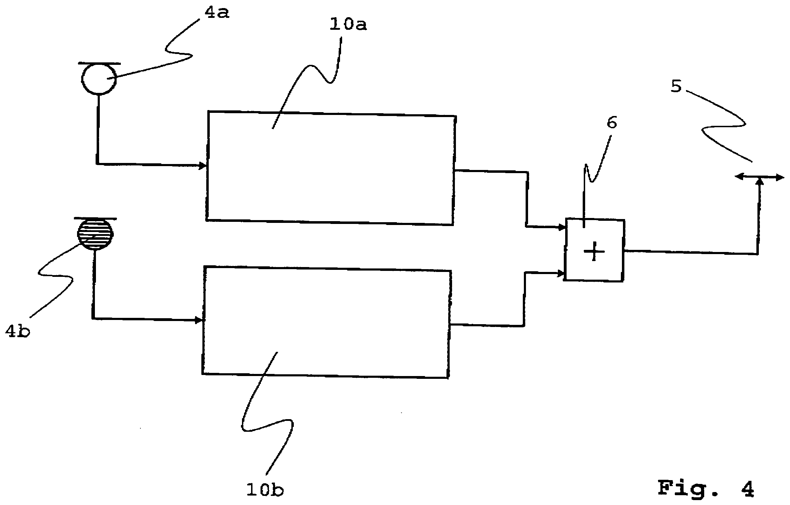

Die Figur 4 zeigt dagegen ein Blockschaltbild eines Paares von Sensoren 4a und 4b in einer zweiten Ausführungsform der Erfindung. Diese sieht vor, jeweils ein eigenes Rückkopplungsregelungssystem 10a und 10b für die Geophone 4a und die Beschleunigungsaufnehmer 4b zu verwenden und die Zusammenführung 6 erst im Aktuatorsignal vorzunehmen. Dem Geophon als ersten Beschleunigungssensor 4a, ist eine erste Regeleinrichtung 10a und dem Beschleunigungsaufnehmer als zweitem Beschleunigungssensor 4b ist eine zweite Regeleinrichtung 10b zugeordnet. Dabei wird ein Regelsystem 10 des Standes der Technik quasi gedoppelt und das ergänzte zweite dazu verwendet, mittels der Beschleunigungsaufnehmer 4b eine hochfrequente Regelung zu realisieren. Lediglich im Aktuatorzweig ist eine Zusammenführung der Stellsignale erforderlich. Hierbei ist darauf zu achten, dass die jeweiligen Signalkomponenten sich nicht so addieren, dass eine Amplitudenüberhöhung stattfindet.

Zusammenfassend sieht die Erfindung den Einsatz einer Kombination von Geophonen 4a und Beschleunigngsaufnehmern 4b zum Zwecke der Schwingungsisolation durch eine Rückkopplungsregelung mit sehr hoher Bandbreite in zwei Ausführungsformen vor. In einer ersten Ausführungsform erfolgt eine Addition beider Sensorsignale zu einem virtuellen Sensorsignal mit hoher Frequenzbandbreite. Die Addition kann in analoger, in digitaler oder in hybrider Weise erfolgen. In einer zweiten Ausführungsform erfolgt die Regelung in den beiden Frequenzbereichen durch getrennte Regelungssysteme mit den jeweiligen Sensoren 4a und 4b als Eingängen, wobei die Addition 6 erst zum Zeitpunkt der Bereitstellung des Aktorsignals erfolgt. Es ist dem Fachmann ersichtlich, dass die beschriebenen Ausführungsformen beispielhaft zu verstehen sind. Die Erfindung ist nicht auf diese beschränkt sondern kann in vielfältiger Weise variiert werden. Merkmale einzelner Ausführungsformen und die im allgemeinen Teil der Beschreibung genannten Merkmale können jeweils untereinander als auch miteinander kombiniert werden.

### Bezugszeichenliste

- 1: Schwingungsisolationssystem
- 2: Lager
- 3: Last

- 4: Sensor oder Schwingungssignalgeber
- 4a: Geophonsensor oder erster Beschleunigungssensor
- 4b: Beschleunigungsaufnehmer oder zweiter Beschleunigungssensor

- 5: Aktor
- 5: Mittel zum Addieren der Signale

- 10: Regeleinrichtung
- 10a: Erste Regeleinrichtung oder erstes Regelungssystem
- 10b: Zweite Regeleinrichtung oder zweites Regelungssystem

## Patentansprüche

1. Aktives Schwingungsisolationssystem (1) zur schwingungsisolierten Lagerung von Lithographie-Einrichtungen, Wafer-Handhabungssystemen und/oder Mikroskopen, umfassend
- eine Vielzahl von Schwingungssignalgebern (4a, 4b) zur Lieferung von Schwingungen repräsentierenden Sensorsignalen,
- eine Anzahl von Aktoren (5) zur Schwingungskompensation, welche durch Zuführen von Aktor-Stellsignalen ansteuerbar sind,
- eine Regeleinrichtung (10, 10a, 10b), die zum Verarbeiten der gelieferten Sensorsignale in die Aktor-Stellsignale ausgebildet ist,
- **dadurch gekennzeichnet, dass** die Schwingungssignalgeber (4a, 4b)
wenigstens einen ersten Beschleunigungssensor (4a), welcher als Geophonsensor ausgebildet ist, zur Erfassung von Schwingungen in einem ersten Frequenzbereich und
wenigstens einen zweiten, gegenüber dem ersten unterschiedlichen Beschleunigungssensor (4b) zur Erfassung von Schwingungen in einem zweiten Frequenzbereich, welcher den ersten Frequenzbereich erweitert und welcher bis zu einem Frequenzbereich von mindestens bis 1,5 kHz wirksam ist, aufweisen,
wobei der erste Beschleunigungssensor (4a) und der zweite Beschleunigungssensor (4b) in einem Abstand von kleiner als 30 cm so angeordnet sind, dass Störgrößen aus der gleichen Richtung erfassbar sind.

2. Schwingungsisolationssystem (1) nach vorstehendem Anspruch, **dadurch gekennzeichnet, dass** der erste Beschleunigungssensor (4a) in dem ersten Frequenzbereich in einem Bereich von bis zu 300 Hz wirksam ist.

3. Schwingungsisolationssystem (1) nach einem der vorstehenden Ansprüche, **dadurch gekennzeichnet, dass** der zweite Beschleunigungssensor (4b) ein piezo-elektrischer Beschleunigungssensor ist.

4. Schwingungsisolationssystem (1) nach einem der vorstehenden Ansprüche, **gekennzeichnet durch** eine Schaltung (6) zum Zusammenführen der Sensorsignale des ersten Beschleunigungssensors (4a) und der Sensorsignale des zweiten Beschleunigungssensors (4b) zu gemeinsamen Aktor-Stellsignalen zum Ansteuern der Aktoren (5).

5. Schwingungsisolationssystem (1) nach einem der vorstehenden Ansprüche, **dadurch gekennzeichnet, dass** der erste und der zweite Beschleunigungssensor (4a bzw. 4b) der Regeleinrichtung (10) zugeordnet sind.

6. Schwingungsisolationssystem (1) nach einem der vorstehenden Ansprüche, **dadurch gekennzeichnet, dass** die Regeleinrichtung (10) eingangsseitig mit der Schaltung (6) zum Zusammenführen gekoppelt ist.

7. Schwingungsisolationssystem (1) nach einem der vorstehenden Ansprüche, **dadurch gekennzeichnet, dass** die Regeleinrichtung (10) ausgangsseitig mit den Aktoren (5) gekoppelt ist.

8. Schwingungsisolationssystem (1) nach einem der vorstehenden Ansprüche 1 bis 7, **dadurch gekennzeichnet, dass** die Regeleinrichtung (10) eine erste Regeleinrichtung (10a), welcher der erste Beschleunigungssensor (4a) zugeordnet ist, und eine zweite Regeleinrichtung (10b), welcher der zweite Beschleunigungssensor (4b) zugeordnet ist, umfasst.

9. Schwingungsisolationssystem (1) nach vorstehendem Anspruch, **dadurch gekennzeichnet, dass** die erste und die zweite Regeleinrichtung (10a bzw. 10b) ausgangsseitig mit der Schaltung (6) zum Zusammenführen gekoppelt sind.

10. Schwingungsisolationssystem (1) nach einem der beiden vorstehenden Ansprüche, **dadurch gekennzeichnet, dass** die Schaltung (6) zum Zusammenführen ausgangsseitig mit den Aktoren (5) gekoppelt ist.

11. Verfahren zum Regelung eines Schwingungsisolationssystems (1) zur schwingungsisolierten Lagerung von Lithographie-Einrichtungen, Wafer-Handhabungssystemen und/oder Mikroskopen,
- Erfassen von Schwingungen mittels einer Vielzahl von Schwingungssignalgebern (4, 4a, 4b),
- Bereitstellen von Sensorsignalen, welche die erfassten Schwingungen repräsentieren,
- Verarbeiten der bereitgestellten Sensorsignale zu Aktor-Stellsignalen zum Steuern von Aktoren (5),
- Zuführen der Aktor-Stellsignale zu den Aktoren (5) zum Entgegenwirken der Schwingungen, **dadurch gekennzeichnet, dass** die Schwingungssignalgeber (4, 4a, 4b) durch
wenigstens einen ersten Beschleunigungssensor (4a) zur Erfassung von Schwingungen in einem ersten Frequenzbereich bis 300 Hz und
wenigstens einen zweiten, gegenüber dem ersten unterschiedlichen Beschleunigungssensor (4b) zur Erfassung von Schwingungen in einem zweiten Frequenzbereich bis mindestens 1,5 kHz, welcher den ersten Frequenzbereich erweitert, bereitgestellt werden, und
die Sensorsignale des ersten Beschleunigungssensors (4a) und die Sensorsignale des zweiten Beschleunigungssensors (4b) zu gemeinsamen Aktor-Stellsignalen zum Ansteuern der Aktoren (5) zusammengeführt werden.

## Claims

1. Active vibration isolation system (1) for vibration-isolated support of lithographic devices, wafer handling systems, and/or microscopes, comprising
- a plurality of vibration transducers (4a, 4b) for supplying sensor signals which are representative of vibrations,
- a number of actuators (5) for vibration compensation which may be controlled by supplying actuator control signals,
- a control device (10, 10a, 10b) which is provided for processing the supplied sensor signals to form the actuator control signals,
- **characterized in that** the vibration transducers (4a, 4b)
have at least one first acceleration sensor (4a), which is embodied as a geophone sensor, for detecting vibrations in a first frequency range and
at least one second acceleration sensor (4b), which is different from the first acceleration sensor, for detecting vibrations in a second frequency range which extends the first frequency range and which is at least effective in a range of up to 1.5 kHz,
wherein the first and second acceleration sensors (4a and 4b, respectively) are spaced less than 30 cm apart, so that disturbance variables from the same direction can be determined.

2. Vibration isolation system (1) according to the preceding claim, **characterized in that** in the first frequency range the first acceleration sensor (4a) is effective in a range of up to 300 Hz.

3. Vibration isolation system (1) according to one of the preceding claims, **characterized in that** the second acceleration sensor (4b) is a piezoelectric acceleration sensor.

4. Vibration isolation system (1) according to one of the preceding claims, **characterized by** a circuit (6) for combining the sensor signals from the first acceleration sensor (4a) and the sensor signals from the second acceleration sensor (4b) to form joint actuator control signals for controlling the actuators (5).

5. Vibration isolation system (1) according to one of the preceding claims, **characterized in that** the first and second acceleration sensors (4a and 4b, respectively) are associated with the control device (10).

6. Vibration isolation system (1) according to one of the preceding claims, **characterized in that** the control device (10) is connected on the input side to the circuit (6) for the combination.

7. Vibration isolation system (1) according to one of the preceding claims, **characterized in that** the control device (10) is connected on the output side to the actuators (5).

8. Vibration isolation system (1) according to one of preceding Claims 1 through 7, **characterized in that** the control device (10) comprises a first control device (10a) which is associated with the first acceleration sensor (4a), and a second control device (10b) which is associated with the second acceleration sensor (4b).

9. Vibration isolation system (1) according to the preceding claim, **characterized in that** the first and second control devices (10a and 10b, respectively) are connected on the output side to the circuit (6) for the combination.

10. Vibration isolation system (1) according to one of the two preceding claims, **characterized in that** the circuit (6) for the combination is connected on the output side to the actuators (5).

11. Method for controlling a vibration isolation system (1) for vibration-isolated support of lithographic devices, wafer handling systems, and/or microscopes, [comprising the following steps]:
- Detecting vibrations by use of a plurality of vibration transducers (4, 4a, 4b),
- Providing sensor signals which represent the detected vibrations,
- Processing the provided sensor signals to form actuator control signals for controlling actuators (5),
- Supplying the actuator control signals to the actuators (5) for counteracting the vibrations,
**characterized in that** the vibration transducers (4, 4a, 4b) are provided by
at least one first acceleration sensor (4a) for detecting vibrations in a first frequency range up to 300 Hz, and
at least one second acceleration sensor (4b), which is different from the first acceleration sensor, for detecting vibrations in a second frequency range up to at least 1,5 kHz, which extends the first frequency range, is provided, and
the sensor signals from the first acceleration sensor (4a) and the sensor signals from the second acceleration sensor (4b) are combined into joint actuator control signals for controlling the actuators (5).

## Revendications

1. Système actif d'isolation des vibrations (1) permettant le montage isolé contre les vibrations de dispositifs de lithographie, de systèmes de manipulation de tranche et/ou de microscopes, comprenant :
- une pluralité de générateurs de signaux de vibration (4a, 4b) destinés à délivrer des signaux de capteur représentant des vibrations,
- un certain nombre d'actionneurs (5) permettant une compensation des vibrations, lesquels peuvent être commandés par l'amenée de signaux de commande d'actionneur,
- un dispositif de réglage (10, 10a, 10b), qui est conçu pour convertir les signaux de capteur délivrés en signaux de commande d'actionneur,
- **caractérisé en ce que** les générateurs de signaux de vibrations (4a, 4b) comprennent :
au moins un premier capteur d'accélération (4a), lequel est réalisé sous la forme d'un capteur géophonique, pour la détection de vibrations dans une première plage de fréquences, et
au moins un deuxième capteur d'accélération (4b) différent du premier et destiné à détecter des vibrations dans une deuxième plage de fréquences, lequel augmente la première plage de fréquences et lequel opère jusqu'à une plage de fréquences allant au moins jusqu'à 1,5 kHz,
dans lequel le premier capteur d'accélération (4a) et le deuxième capteur d'accélération (4b) sont agencés à une distance inférieure à 30 cm, de sorte que des grandeurs perturbatrices venant de la même direction peuvent être détectées.

2. Système d'isolation des vibrations (1) selon la revendication précédente, **caractérisé en ce que** le premier capteur d'accélération (4a) dans la première plage de fréquences opère dans une plage allant jusqu'à 300 Hz.

3. Système d'isolation des vibrations (1) selon l'une quelconque des revendications précédentes, **caractérisé en ce que** le deuxième capteur d'accélération (4b) est un capteur d'accélération piézo-électrique.

4. Système d'isolation des vibrations (1) selon l'une quelconque des revendications précédentes, **caractérisé par** un circuit (6) permettant de regrouper les signaux de capteur du premier capteur d'accélération (4a) et les signaux de capteur du deuxième capteur d'accélération (4b) en signaux de commande d'actionneur communs pour commander les actionneurs (5).

5. Système d'isolation des vibrations (1) selon l'une quelconque des revendications précédentes, **caractérisé en ce que** le premier et le deuxième capteur d'accélération (4a ou 4b) sont associés au dispositif de réglage (10).

6. Système d'isolation des vibrations (1) selon l'une quelconque des revendications précédentes, **caractérisé en ce que** le dispositif de réglage (10) est couplé côté entrée au circuit (6) permettant le regroupement.

7. Système d'isolation des vibrations (1) selon l'une quelconque des revendications précédentes, **caractérisé en ce que** le dispositif de réglage (10) est couplé côté sortie aux actionneurs (5).

8. Système d'isolation des vibrations (1) selon l'une quelconque des revendications précédentes 1 à 7, **caractérisé en ce que** le dispositif de réglage (10) comprend un premier dispositif de réglage (10a), auquel est associé le premier capteur d'accélération (4a), et un deuxième dispositif de réglage (10b), auquel est associé le deuxième capteur d'accélération (4b).

9. Système d'isolation des vibrations (1) selon la revendication précédente, **caractérisé en ce que** le premier et le deuxième dispositif de réglage (10a ou 10b) sont couplés côté sortie au circuit (6) permettant le regroupement.

10. Système d'isolation des vibrations (1) selon l'une des deux revendications précédentes, **caractérisé en ce que** le circuit (6) permettant le regroupement est couplé côté sortie aux actionneurs (5).

11. Procédé de réglage d'un système d'isolation des vibrations (1) pour le montage isolé des vibrations de dispositifs de lithographie, de systèmes de manipulation de tranche et/ou de microscopes, comprenant :
- la détection de vibrations au moyen d'une pluralité de générateurs de signaux de vibrations (4, 4a, 4b),
- la fourniture de signaux de capteur, lesquels représentent les vibrations détectées,
- la conversion des signaux de capteur fournis en signaux de commande d'actionneur permettant de commander les actionneurs (5),
- l'amenée des signaux de commande d'actionneur aux actionneurs (5) pour s'opposer aux vibrations, **caractérisé en ce que** les générateurs de signaux de vibrations (4, 4a, 4b) sont fournis par :
au moins un premier capteur d'accélération (4a) destiné à détecter des vibrations dans une première plage de fréquences jusqu'à 300 Hz, et
au moins un deuxième capteur d'accélération (4b) différent du premier et destiné à détecter des vibrations dans une deuxième plage de fréquences jusqu'à au moins 1,5 kHz, lequel augmente la première plage de fréquences, et
les signaux de capteur du premier capteur d'accélération (4a) et les signaux de capteur du deuxième capteur d'accélération (4b) sont regroupés pour obtenir des signaux de commande d'actionneur communs permettant de commander les actionneurs (5).
